# FASCICULE DE BREVET EUROPEEN

(11) **EP 3 575 808 B1**
(45) Date de publication et mention de la délivrance du brevet: **22.02.2023**
(21) Numéro de dépôt: 19169487.6
(22) Date de dépôt: 16.04.2019
(51) Int. Cl.: G01R 31/327, H01H 1/00, H01H 71/04, G01R 31/50

(54) **PROCEDE ET DISPOSITIF DE DIAGNOSTIC D'USURE D'UN APPAREIL ELECTRIQUE DE COUPURE, ET APPAREIL ELECTRIQUE COMPORTANT UN TEL DISPOSITIF**
VERFAHREN UND VORRICHTUNG ZUR DIAGNOSE DER ABNUTZUNG EINES ELEKTRISCHEN STROMUNTERBRECHUNGSGERÄTS, UND ELEKTRISCHES GERÄT, DAS EINE SOLCHE VORRICHTUNG UMFASST
METHOD AND DEVICE FOR DIAGNOSING THE WEAR OF AN ELECTRICAL SWITCHGEAR, AND ELECTRICAL SWITCHGEAR COMPRISING SUCH A DEVICE

(30) Priorité: 01.06.2018 FR 1854786
(43) Date de publication de la demande: 04.12.2019
(73) Titulaire: SCHNEIDER ELECTRIC INDUSTRIES SAS, 92500 Rueil-Malmaison (FR)
(72) Inventeur: ORBAN, Rémy, 38050 Grenoble (FR); DESFORGES, José, 38050 Grenoble (FR)
(74) Mandataire: Schneider Electric

(56) Documents cités:
- EP-A1- 0 665 567
- EP-A1- 1 475 813
- EP-A1- 1 555 683
- EP-A1- 2 584 575
- WO-A1-2013/189527
- DE-A1- 19 804 196
- DE-A1-102011 016 895
- DE-C- 393 641
- US-A1- 2007 222 427
- JOHN J. SHEA: "High Current AC Break Arc Contact Erosion", ELECTRICAL CONTACTS, 2008. PROCEEDINGS OF THE 54TH IEEE HOLM CONFERENCE ON, IEEE, PISCATAWAY, NJ, USA, 27 octobre 2008 (2008-10-27), pages xxii-xlvi, XP031368143, ISBN: 978-1-4244-1901-2

## Description

### DOMAINE TECHNIQUE

L'invention concerne un procédé de diagnostic de l'état d'usure d'un appareil électrique de coupure comportant une phase de contrôle dudit appareil électrique.

L'invention concerne aussi un dispositif de diagnostic et un appareil mettant en oeuvre le procédé.

### ETAT DE LA TECHNIQUE

Les procédés et dispositifs de diagnostic de l'état d'appareils électriques contrôlent généralement une ou plusieurs caractéristiques électriques en les comparant à un gabarit de valeurs. Parmi ces caractéristiques, il y a généralement une tension, un courant ou un repère de temps d'un point remarquable d'un signal électrique. Un procédé de diagnostic de ce type est divulgué dans la demande de brevet EP2584575.

D'autres procédés déterminent l'usure de contacts d'appareils électriques tels que des contacts en évaluant un temps entre deux événements ou la durée d'un événement. Par exemple, un temps entre la commande de l'ouverture ou de fermeture de contacts et le moment effectif de ladite ouverture ou fermeture. Une demande de brevet WO03054895 décrit une façon particulière de détecter l'usure de contacts d'un appareil électrique en fonction du moment de l'apparition d'un courant primaire après un ordre de commande.

Les procédés et dispositifs de diagnostic connus offre des résultats satisfaisants mais ne sont pas faciles à déployer sur des appareils existants ou déjà installés. Généralement, il faut une intervention dans les appareils électriques. De plus, il y a un besoin d'avoir des précisions et des niveaux de certitudes plus élevés pour le contrôle de certains appareils électriques tels que des contacteurs.

Un autre inconvénient des dispositifs connus est leur sensibilité aux variations de température. De tels dispositifs nécessitent aussi des mesures de température afin de compenser l'évaluation de l'usure de contacts électriques.

On connaît le document EP 0 665 567 décrivant un procédé de diagnostic de l'état d'usure d'un appareil électrique de coupure qui utilise des données chargées préalablement correspondant à un type de produit représentatif dudit appareil électrique, le procédé ayant une phase de contrôle qui comporte :
- la mesure et l'acquisition d'une courbe de mesure à l'ouverture dudit appareil électrique, la détermination de valeur de descripteurs locaux de ladite courbe de mesure en fonction de valeurs de ladite courbe de mesure et desdites données chargées préalablement, et dépendant de points remarquables de ladite courbe de mesure, la détermination du positionnement des valeurs de descripteurs locaux, et la détermination d'une classe d'état globale en fonction desdites valeurs de positionnement des valeurs de descripteurs locaux et de la courbe de mesure .

### EXPOSE DE L'INVENTION

L'invention a pour but un procédé et un dispositif de diagnostic d'un appareil électrique fournissant un résultat ayant une certitude améliorée, étant facile à mettre en oeuvre sur des appareils électriques et peu sensible aux variations de température.

La présente invention a pour objet un procédé de diagnostic de l'état d'usure d'un appareil électrique de coupure selon la revendication 1.

Selon un mode de réalisation préférentiel de l'invention, un premier descripteur correspond à une surface de courbe ou à une intégrale ou intégration commençant à un premier point de la courbe le mesure dépendant d'un premier point remarquable de ladite courbe le mesure correspondant à un premier changement de sens de la variation du signal ou de changement de signe de la dérivée dudit signal de mesure, ledit premier point remarquable étant représentatif du début du mouvement d'une partie mobile de l'appareil électrique.

De préférence, l'intégrale du signal commence à un instant t1 compris entre 0 et 10ms avant l'apparition dudit premier point remarquable.

Avantageusement, l'intégrale du signal se termine lorsque le signal de la courbe de tension bobine est nul ou proche de zéro volt. Par exemple, inférieur à 2 Volts en valeur absolue. De préférence, l'intégrale du signal dure entre 30 ms et 40 ms.

Selon un mode de réalisation préférentiel de l'invention, un second descripteur correspond à un positionnement ou à un écart d'un second point remarquable par rapport à une courbe ou une ligne de référence initiale dudit second point remarquable d'un appareil neuf défini sur une plage de température, ledit second point remarquable correspond à une variation de valeur tel que le changement de signe de la variation d'un signal sur la courbe de mesure, ledit signal étant en décroissance puis en croissance en valeur relatives autour du second point rem arquable.

Avantageusement, au moins un descripteur peu sensible à la température a un écart de valeur inférieur à 5% entre -20°C et 80°C.

De préférence, des données d'apprentissage chargées sont représentatives de courbes d'évolution de descripteurs représentatifs de caractéristiques prédéfinies dudit signal électrique durant la vie dudit appareil électriques.

De préférence, lesdites courbes d'évolution de descripteurs sont chargées sous un format de définition de segments de droite pour réduire l'espace mémoire nécessaire audites données d'apprentissage.

Avantageusement, des valeurs desdites courbes d'évolution de descripteurs préchargées sont associées à des classes d'état ou d'usure d'appareils à contrôler.

Selon un mode de réalisation préféré, le procédé comporte :
- une phase d'apprentissage préalable pour relever durant un nombre de manoeuvre prédéterminée des données d'apprentissage représentatives d'au moins deux courbes d'évolution de descripteurs représentatifs de caractéristiques prédéfinies dudit signal électrique durant la vie dudit appareil électrique,
- une mémorisation desdites données d'apprentissage,
- le chargement desdites données d'apprentissage, et
- l'utilisation des données d'apprentissage dans ladite phase de contrôle dudit appareil électrique.

Un dispositif selon l'invention de diagnostic de l'état d'usure d'un appareil de coupure électrique connecté à une bobine électromagnétique d'actionnement de contacts dudit appareil de coupure comporte un circuit de traitement pour mettre en oeuvre le procédé de diagnostic tel que défini ci-dessus.

De préférence, le circuit de traitement comporte un module de traitement du diagnostic local proche dudit l'appareil relié à un module de traitement extérieur distant dudit appareil.

Un appareil électrique selon l'invention comportant des contacts électriques de puissance actionnés par une bobine électromagnétique de commande comporte un dispositif de diagnostic l'état d'usure de l'appareil de coupure électrique connecté à ladite bobine électromagnétique d'actionnement desdits contacts et mettant en oeuvre le procédé de diagnostic tel que défini ci-dessus.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma global d'un appareil électrique comportant un dispositif de contrôle selon un mode de réalisation de l'invention ;
- la figure 2 représente une phase d'apprentissage d'un procédé selon un mode de réalisation de l'invention ;
- la figure 3 représente une phase de chargement d'un dispositif et d'un procédé selon un mode de réalisation de l'invention ;
- la figure 4 représente une phase d'initialisation et de traitement d'un dispositif et d'un procédé selon un mode de réalisation de l'invention ;
- la figure 5 représente des courbes de mesure d'un signal lors de l'ouverture d'un appareil électrique à contrôler pour différentes températures de fonctionnement ;
- la figure 6 représente un premier descripteur pour un dispositif et un procédé selon un mode de réalisation de l'invention ;
- la figure 7 représente des courbes de variations en fonction de la température d'un premier descripteur pour un dispositif et un procédé selon un mode de réalisation de l'invention et d'un point de remarquable ;
- la figure 8 représente une courbe d'évolution d'un premier descripteur élaborée lors d'une phase d'apprentissage et utilisée dans un dispositif et un procédé selon un mode de réalisation de l'invention ;
- les figures 9 et 10 représentent une modélisation d'un second descripteur pour un dispositif et un procédé selon un mode de réalisation de l'invention ;
- la figure 11 représente des courbes de variations en fonction de la température d'un deuxième descripteur pour un dispositif et un procédé selon un mode de réalisation de l'invention et d'un point de remarquable ;
- la figure 12 représente une courbe d'évolution d'un second descripteur élaborée lors d'une phase d'apprentissage et utilisée dans un dispositif et un procédé selon un mode de réalisation de l'invention ;
- la figure 13 représente une courbe de mesure de signal pour un appareil en bon état ou neuf et une courbe de mesure de signal pour un appareil usé ;
- la figure 14 représente des étapes de la phase de d'initialisation d'un procédé selon un mode de réalisation de l'invention ;
- la figure 15 représente une phase de contrôle d'un procédé selon un mode de réalisation de l'invention ; et
- la figure 16 représente des étapes d'une phase de contrôle d'un procédé selon un mode de réalisation de l'invention.

### DESCRIPTION DETAILLEE DE MODES DE REALISATION

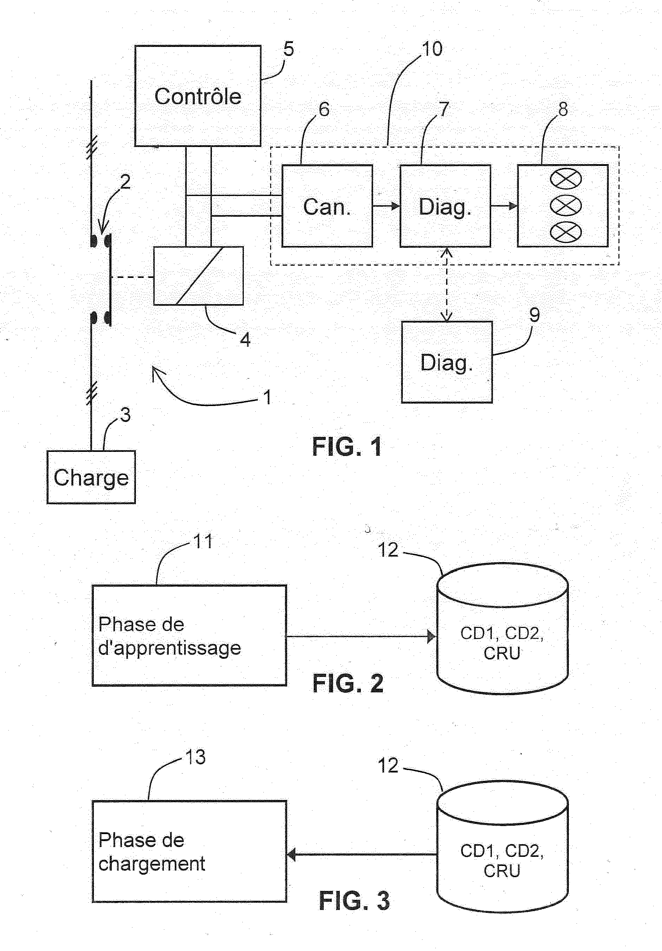

Sur la figure 1, un appareil électrique 1 de type contacteur comporte un ou plusieurs contacts 2 électriques de puissance pour alimenter ou interrompre l'alimentation électrique d'une charge 3. Les contacts électriques sont commandés par une bobine électromagnétique 4. Un circuit 5 de commande ou de contrôle commande la bobine 4 électromagnétique pour fermer ou ouvrir les contacts 2. Le circuit 5 contrôle aussi un courant circulant dans la bobine durant une phase d'appel au moment de la fermeture des contacts et durant une phase de maintien des contacts fermés avec une énergie et un courant de commande réduits.

Un dispositif de diagnostic 10 de l'usure de l'appareil 1 est associé ou fait partie de l'appareil électrique. Ce dispositif 10 reçoit un signal représentatif d'une grandeur électrique telle que la tension ou le courant de la bobine 4 de commande des contacts. Avantageusement, le dispositif 10 est connecté en parallèle sur la bobine pour recevoir un signal de tension généré par la bobine lors de l'ouverture des contacts. Un signal de courant circulant dans la bobine peut aussi être utilisé. Cependant, dans un mode de réalisation préférentiel, un signal de tension est avantageusement plus stable et facile à utiliser. Ainsi, le dispositif 10 comporte un convertisseur 6 Analogique-Numérique connecté à la bobine 4, un module de diagnostic 7 connecté au convertisseur pour recevoir le signal et traiter le diagnostic de l'appareil électrique, et un dispositif 8 de signalisation de l'état de l'appareil électrique, notamment son niveau d'usure des contacts. Le module de diagnostic 7 peut aussi être connecté et traiter des données avec un autre module 9 de traitement extérieur ou déporté. Dans ce cas, le dispositif de diagnostic est en deux ou plusieurs parties. Il est également possible que des parties extérieures soient communes à plusieurs dispositifs ou centralisées. Le module de traitement 9 peut assurer la signalisation à distance de l'état de l'appareil. Bien entendu, les communications entre les modules et les dispositifs se font avec ou sans fil.

Ainsi, le contrôle et le diagnostic de l'usure de l'appareil électrique tel qu'un contacteur est fait de préférence par l'analyse de la tension de la bobine à l'ouverture dudit contacteur. Cette tension est représentative de la vitesse du mouvement de la partie mobile du contacteur. Dans ce cas, l'usure des contacts entraine une diminution de la vitesse de déplacement de la partie mobile de l'appareil électrique.

Le diagnostic de l'état d'usure de l'appareil électrique comporte une phase d'apprentissage préalable réalisée sur un nombre important de produits pendant des cycles de durée de vie desdits appareils. Avantageusement, l'apprentissage peut également être réalisé par simulation numérique afin de déterminer une relation entre l'évolution des descripteurs, notamment D1, D2, et une grandeur caractéristique de l'état de l'appareil comme l'usure des contacts. Cette phase d'apprentissage permet acquérir des données d'apprentissage qui seront d'abord mémorisées, modélisées et stockées puis chargées sur chaque appareil à contrôler pour le contrôle de sa propre usure. La figure 2 illustre une phase d'apprentissage 11 et le stockage 12 des données d'apprentissage.

Durant la phase d'apprentissage des courbes de mesures sont acquises lors de l'ouverture des appareils en cycle d'usure. Des courbes de mesure représentent un signal électrique qui dure quelques dizaines de millisecondes par exemple 30 ms à 50 ms pour un appareil électrique de taille moyenne. Ces durées peuvent être très différentes selon la taille et le type des appareils. Le signal est généralement échantillonné avec quelques centaines d'échantillon par exemple entre 80 et 500 échantillons mais un nombre différent peut aussi être utilisé, il dépendra de la capacité de calcul d'un processeur utilisé dans le dispositif de diagnostic.

Pendant la phase d'apprentissage, les appareils électriques subissent les quantités de manoeuvres permettant de suivre la vie d'un appareil. Pour un contacteur, le nombre de manoeuvres peut atteindre par exemple 800000 bien que d'autres valeurs puissent être aussi utilisées. Le nombre de données pouvant être considérable, l'évolution des caractéristiques de l'appareil électrique est définie par des descripteurs D1, D2, peu sensibles aux variations de température associés à des caractéristiques électriques et à des courbes d'évolution CD1, CD2 desdits descripteurs durant la vie d'un appareil électrique. Pour réduire encore la taille des données d'apprentissage qui seront par la suite chargées dans les dispositifs des appareils à diagnostiquer, les courbes d'évolution CD1, CD2 des descripteurs sont enregistrées sous la forme de données représentatives de segments de droites de type a + bx. Une courbe d'évolution peut avoir plusieurs segments de droites successifs définissant la durée de vie d'un appareil. L'ensemble de courbes d'évolution des descripteurs CD1, CD2, forme, sur la vie d'un produit, un espace à plusieurs dimensions. Des parties, portions de courbes ou des valeurs de descripteurs sont associées à des classes d'état ou d'usure de l'appareil électrique. Vu le nombre de manoeuvres des appareils, les courbes de mesures ne sont pas obligatoirement acquises à chaque ouverture. L'acquisition des courbes de mesure peuvent être espacées de manières régulières par intervalles de nombre de manoeuvres ou de manières plus pertinentes en fonction de l'évolution des appareils. Par exemple le nombre de manoeuvres peut être plus fréquent en fin de vie et très espacé en début de vie.

La phase d'apprentissage peut fournir également une courbe de référence usée CRU. Cette courbe de référence usée est prélevée sur des courbes de mesure en fin de vie des appareils servant à l'apprentissage. La courbe de référence usée CRU peut être une courbe moyennée sur plusieurs courbes de mesure et/ou sur plusieurs appareils usés.

Ainsi, à la fin de la phase d'apprentissage, les données d'apprentissage telles que les courbes d'évolution CD1, CD2, des descripteurs et éventuellement la courbe de référence usée CRU sont d'abord mémorisées, modélisées et stockées puis chargées sur chaque appareil pour le contrôle de sa propre usure. Ces données d'apprentissage sont communes à tous les dispositifs de contrôle associés à un même type d'appareil. La figure 3 illustre une phase de chargement 13 de données d'apprentissage préalablement stockées dans des appareils à diagnostiquer.

Dans un premier mode de réalisation préféré, un procédé de diagnostic selon l'invention comporte :
- une phase 11 d'apprentissage préalable pour relever durant un nombre de manoeuvre prédéterminée des données d'apprentissage représentatives d'au moins deux courbes d'évolution de descripteurs représentatifs de caractéristiques prédéfinies dudit signal électrique durant la vie dudit appareil électrique,
- une mémorisation 12 desdites données d'apprentissage CD1, CD2,
- le chargement 13 desdites données d'apprentissage CD1, CD2, et
- l'utilisation des données d'apprentissage dans ladite phase 15 de contrôle dudit appareil électrique.

Dans un mode de réalisation préféré, un procédé de diagnostic selon l'invention comporte aussi une phase d'initialisation 14 pour déterminer des données d'initialisation comportant une courbe de référence propre CRP du produit à contrôler, et l'utilisation desdites données d'initialisation dans une phase de contrôle 15 dudit appareil électrique.

Lors de la phase de contrôle, des descripteurs locaux DL1, DL2, peu sensibles aux variations de température propres à chaque appareil à contrôler sont déterminés lors de l'acquisition de courbes de mesures CM. Ces descripteurs sont du même type que ceux qui ont servis à élaborer des courbes globales CD1, CD2, d'évolution des descripteurs, peu sensibles aux variations de température. Dans le mode de réalisation préféré comportant au moins deux descripteurs D1, D2 peu sensibles aux variations de température, ces descripteurs donneront respectivement des courbes globales CD1, CD2 d'évolution préalablement élaborées enregistrées et chargées, et respectivement deux descripteurs locaux DL1, DL2 propres à chaque appareil issu de courbes de mesure lors de l'ouverture de l'appareil électrique.

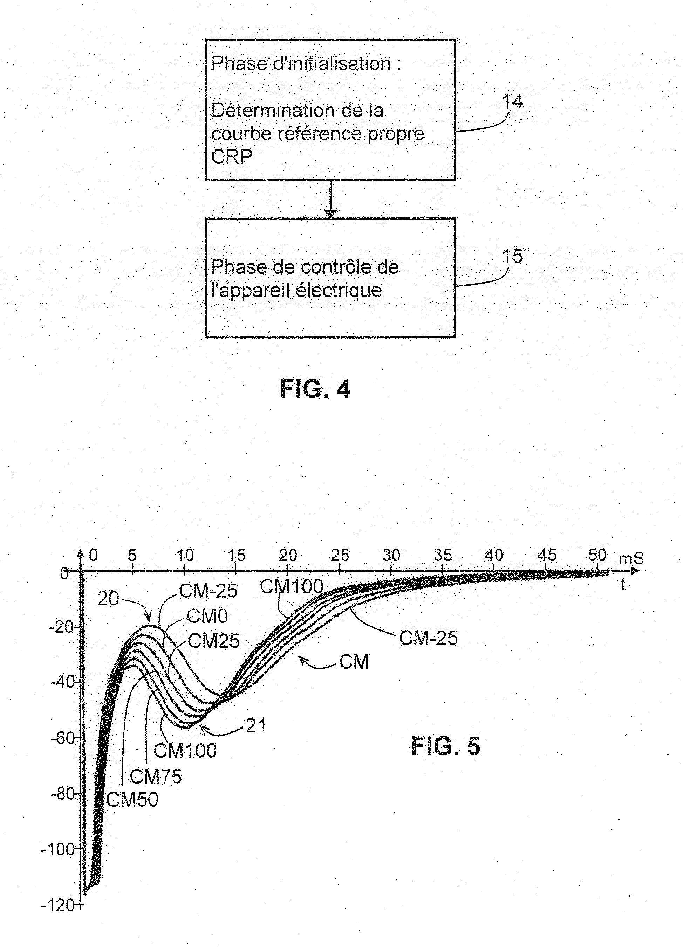

La figure 5 montre des courbes de mesure CM, soit CM-25, CM0, CM25, CM50, CM75, CM100 représentatives d'un signal de tension électrique une bobine de commande à l'ouverture d'un appareil électrique pour différentes températures de fonctionnement respectivement -25, 0, 25, 50, 75, et 100 degrés Celsius. Une telle courbe peut être aussi bien une courbe de mesure CM lors de la phase de contrôle d'un appareil électrique qu'une courbe de mesure pendant la phase d'apprentissage pour élaborer les courbes d'évolution des descripteurs. Sur ces courbes, un premier point remarquable 20 correspond au premier changement de sens de la variation de tension de la courbe CM avec une croissance puis une décroissance en valeur relatives. Le point 20 est aussi repéré comme la première inversion de la dérivée du signal. Ensuite, un second point remarquable 21 correspond au second changement de sens de la variation de tension de la courbe CM avec une décroissance puis une croissance en valeur relatives. Au second point remarquable 21, il y a une seconde inversion de la dérivée du signal des courbes CM de mesure.

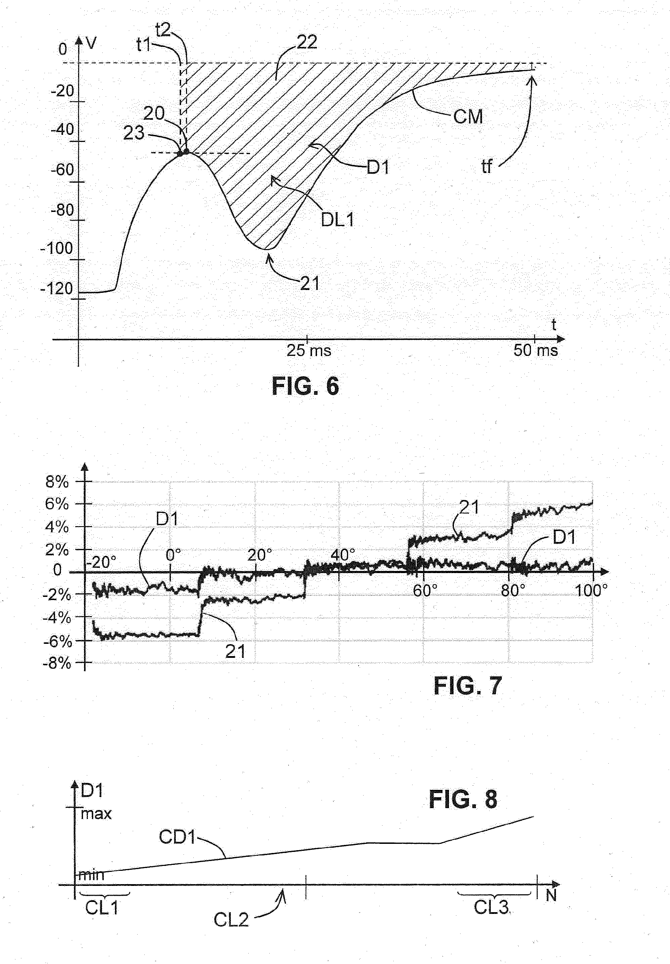

La figure 6 représente un premier descripteur D1 pour un dispositif et un procédé selon un mode de réalisation de l'invention. Ce premier descripteur D1 correspond à une surface 22 de la courbe CM ou à une intégrale ou intégration commençant à un premier point 23 de la courbe le mesure CM. Le dit premier point 23 dépend du premier point remarquable 20 de la courbe le mesure CM correspondant à un premier changement de sens de la variation du signal ou changement de signe de la dérivée dudit signal de mesure. Le premier point remarquable 20 étant représentatif du début du mouvement de la partie mobile de l'appareil électrique. Le premier descripteur D1 est aussi une représentation de décrochage c'est-à-dire du flux magnétique au moment où l'effort du ressort de pression des contacts devient supérieur à l'effort magnétique correspondant aussi au début de l'ouverture de la partie mobile de l'appareil. Ainsi, ce descripteur D1 déterminé par une intégrale dont le début dépend du premier point remarquable 20 est très sensible à l'usure des pastilles de contacts et très peu sensible aux variations de température. Le descripteur D1 est basé essentiellement sur les comportements du flux magnétique dépendant de l'usure des contacts. De préférence, l'intégrale 22 du signal commence à un instant t1 compris entre 10 ms et 0 ms avant l'apparition du premier point remarquable 20 à un instant t2 selon le comportement dynamique de l'appareil électrique. Sur la figure 6, l'intégrale du signal se termine à la fin tf de la capture du signal de la courbe CM. Dans un mode de fonctionnement préférentiel, l'intégrale 22 se termine lorsque le signal tension bobine est sensiblement nul proche de zéro volt, par exemple, inférieur à 2 Volts en valeur absolue. Cependant, elle peut être limitée à une durée fixe, par exemple l'intégration du signal peut durer entre 30 ms et 40 ms.

La figure 7 représente des courbes de variations en fonction de la température d'un premier descripteur D1 pour un dispositif et un procédé selon un mode de réalisation de l'invention et d'un second point de remarquable 21 seul. Cette comparaison montre que le descripteur D1 déterminé par une intégrale 22 a une précision inférieure à +- 2% sur une plage de température de -20 °C à 100 °C alors que le point 21 seul peut atteindre +- 6 %. Globalement entre 0 et 100 °C le descripteur D1 est 10 fois moins sensible aux variations de température qu'un descripteur basé sur le point 21 seul.

La figure 8 représente une courbe d'évolution CD1 d'un premier descripteur D1 élaborée lors d'une phase d'apprentissage et utilisée dans un dispositif et un procédé selon un mode de réalisation de l'invention.

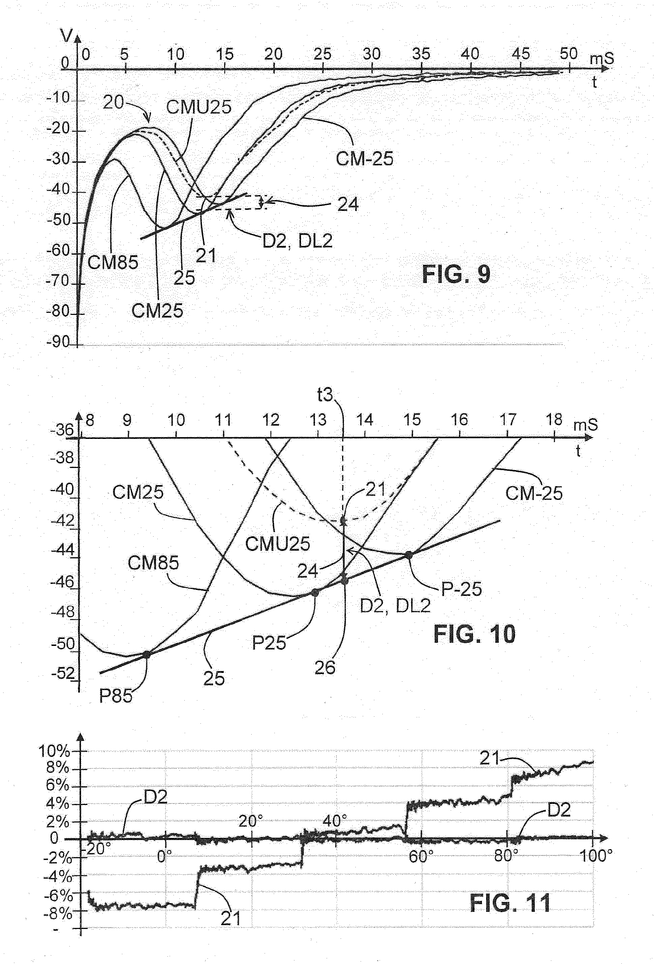

Les figures 9 et 10 représentent une modélisation d'un second descripteur D2 pour un dispositif et un procédé selon un mode de réalisation de l'invention. Le second descripteur D2 correspond à un positionnement ou à un écart 24 d'un second point remarquable 21 d'un signal mesuré sur une courbe CM par rapport à une courbe ou une ligne 25 de référence initiale définie par rapport à des seconds points remarquables 21, P-25, P25, P85 d'un appareil neuf définis sur une plage de température, par exemple -25 à 85 °C. Ledit second point remarquable 21 correspond à une variation de valeur tel que le changement de signe de la variation d'un signal sur la courbe de mesure CM, ledit signal étant en décroissance puis en croissance en valeur relatives autour du second point remarquable. Sur les figures 9 et 10 les seconds points remarquables P-25, P25, P85 d'un appareil neuf sont définis avec trois valeurs de température respectivement -25, 25 et 85 °C. En utilisant une ligne de référence 25 dépendante d'un appareil neuf sur une plage de température et en vérifiant le positionnement d'un point remarquable 21 d'un appareil à contrôler à cette courbe de référence, le descripteur D2 représentatif de cet écart 24 devient peu sensible à la température puisque les effets variations de températures sont compensées automatiquement.

Sur la figure 9 en vue complète de l'acquisition de la mesure et sur la figure 10 en vue détaillée, les courbes CM-25, CM25 et CM85 correspondent à des courbes lors de l'apprentissage pour différentes températures respectivement -25, 25 et 85 °C. Des points remarquables 21 de l'appareil neuf P-25, P25, P85 en phase d'apprentissage pour différentes températures respectivement -25, 25 et 85 °C permettent de définir une ligne de référence 25. Cette ligne est de préférence linéaire mais elle peut prendre différentes formes plus complexes. L'écart 24 donne le second descripteur D2 en comparant une valeur du second point remarquable 21 d'un appareil à contrôler qui peut être usé à la ligne de référence 25. Sur la figure 10, à un instant t3, le second point remarquable 21 d'un appareil usé est détecté, ce point est alors comparé à une valeur 26 de la courbe de référence 25 aux environs du même instant t3. A cet instant t3, la valeur de l'écart 24 permet de déterminer une valeur du descripteur D2.

La figure 11 représente des courbes de variations en fonction de la température d'un deuxième descripteur D2 pour un dispositif et un procédé selon un mode de réalisation de l'invention et d'un point de remarquable 21 seul. Cette comparaison montre que le descripteur D1, déterminé par un écart d'un point 21 d'un appareil à contrôler par rapport à une ligne de référence de points 21 d'appareils neufs à différentes températures préenregistrée, a une précision inférieure à +- 1% sur une plage de température de -20 °C à 100 °C alors que le point 21 seul peut atteindre +- 8 %. Ce mode de détermination du descripteur D2 opère une auto compensation en température.

Les descripteurs D1 et D2 peu sensibles à la température, aux différences de température ou aux variations de température, sont choisis ou sélectionnés pour avoir un écart de valeur inférieur à 5% entre -20°C et 80°C. Ainsi selon un mode de réalisation de l'invention, au moins un descripteur peu sensible à la température D1, DL1, D2, DL2 a un écart de valeur inférieur à 5% entre -20°C et 80°C.

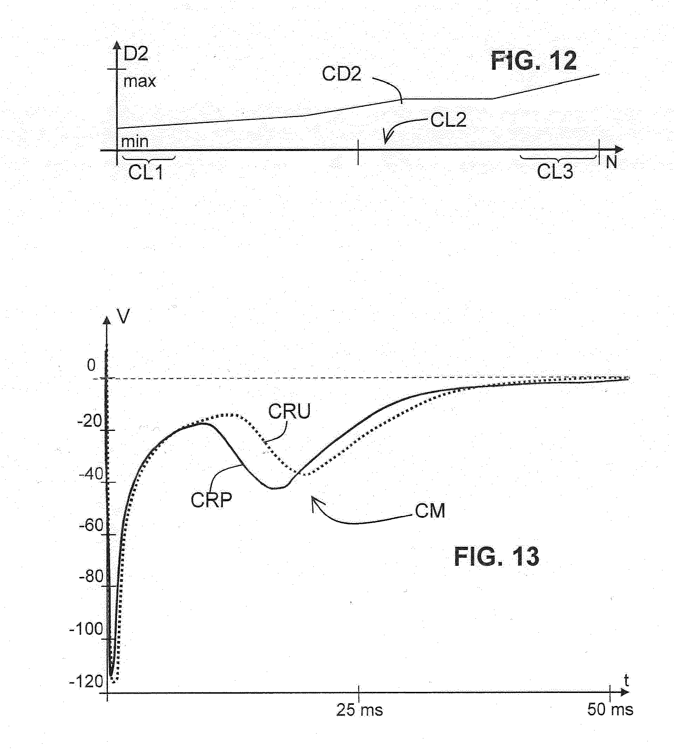

La figure 12 représente une courbe d'évolution d'un second descripteur D2 élaborée lors d'une phase d'apprentissage et utilisée dans un dispositif et un procédé selon un mode de réalisation de l'invention.

Des courbes CD1 et CD2 représentatives de l'évolution des descripteurs D1 et D2 sont issues de courbes d'apprentissage relevées pendant la phase d'apprentissage avec un nombre très important de mesures. Ensuite, ces nombreuses valeurs ont été modélisées en segments de droites pour donner les courbes d'évolution des descripteur CD1 et CD2 qui seront chargées dans les appareils à contrôler. Ces courbes montrées en figures 8 et 12 comprennent par exemple quelques segments. Le nombre de segments n'est pas limité, il est avantageusement compris entre 1 et 20. Cependant, d'autres modes de modélisation sont possibles, par exemple par paliers ou par polynômes. Ainsi, les données d'apprentissage chargées sont représentatives de courbes d'évolution CD1, CD2 de descripteurs représentatifs de caractéristiques prédéfinies dudit signal électrique durant la vie de l'appareil électriques.

En début de courbes globales CD1, CD2, d'évolution des descripteurs, les descripteurs sont associés à des classes particulières CL1 d'appareils neufs ou en rodage alors qu'en fin de courbes les descripteurs sont associés à des classes CL3 d'appareils usés. Entre les classes CL1 et CL3, les descripteurs sont associés à des classes CL2 d'appareils en fonctionnement normal.

L'utilisation d'au moins deux ou plusieurs descripteurs D1, D2, permet de détecter avec plus de précision ou de certitude l'état d'usure d'un appareil électrique à contrôler. Les descripteurs décrits ci-dessus dépendent de grandeurs électriques. Cependant, d'autres descripteurs peuvent aussi être utilisés en combinant des grandeurs électriques et des grandeurs environnementales telles que la température ou la position horizontale ou verticale d'un appareil. De telles grandeurs peuvent servir à sélectionner des descripteurs en fonction de l'environnement. Les courbes de descripteurs peuvent aussi être sélectionnées en fonction du type d'utilisation particulier de l'appareil électrique. Des données de paramétrage permettant de définir le type de produit ou d'appareil électrique et l'usage dudit appareil sont aussi chargées avec les données d'apprentissage correspondante lors de la phase de chargement.

Lorsque les données d'apprentissage sont chargées dans un dispositif prêt à opérer le diagnostic de l'usure d'un appareil électrique tel qu'un contacteur. Une phase d'initialisation permet de mémoriser des données initiales propres à l'appareil à contrôler. Parmi ces caractéristiques initiales, il y a avantageusement l'acquisition d'une courbe de référence propre CRP. Cette courbe de référence est de préférence mémorisée après un rodage de l'appareil correspondant à un nombre prédéterminé de premières ouvertures et/ou lorsque des variations de courbe de mesure CM deviennent stables.

La figure 13 montre deux exemples de courbes. Une première courbe de mesure CM appareil neuf qui peut être aussi une courbe de référence propre CRP, et une courbe de mesure CM appareil usée qui peut être aussi une courbe de référence appareil usé CRU pouvant être préchargée. Les autres courbes de mesure de mesure CM durant la vie de l'appareil vont se situer entre ces deux courbes de références CRP et CRU.

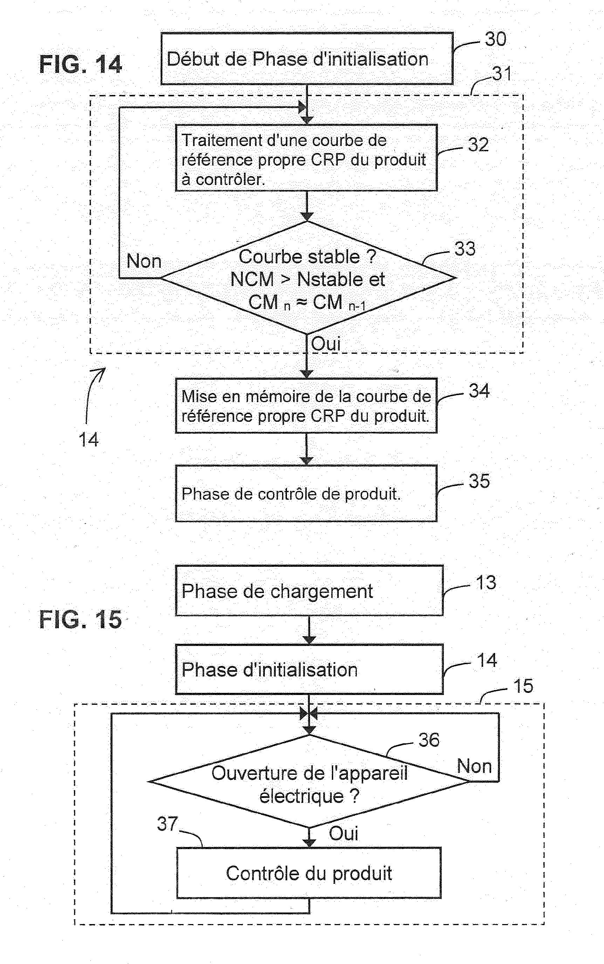

La figure 14 montre un organigramme représentant une phase d'initialisation 14 pour déterminer lesdites données d'initialisation comportant ladite courbe de référence propre CRP du produit à contrôler sur lequel est installé ou associé le dispositif de contrôle. Une étape 30 montre le début de la phase d'initialisation. Un processus 31 de détermination d'une courbe de référence propre CRP comporte une étape de traitement 32 ou sont acquises des courbes de mesures consécutives et une étape 33 de contrôle de la stabilité de la courbe. La courbe CM est reconnue stable après un nombre prédéterminé de mesures Nstable, et/ou lorsque la courbe de mesure CM varie très peu entre deux mesures consécutives CMn et CMn-1.

A une étape 34, la courbe de mesure CM est enregistrée en tant que courbe de référence propre CRP. Après un nombre minimum de manoeuvres lorsque les écarts entre les courbes après chaque ouverture deviennent faibles. Cette courbe est représentative des caractéristiques électriques de la tension ou du courant en début de vie du produit après rodage. Elle reste valable jusqu'à la fin de vie du produit. Dans un autre mode de réalisation, pour améliorer encore stabilité de la courbe à enregistrer, la courbe de référence propre CRP peut aussi être une moyenne de quelques courbes CM stables. Une étape 35 représente la phase de contrôle du produit.

La figure 15 montre qu'après la phase de chargement 13 où des données d'apprentissage correspondant à un type de produit représentatif dudit appareil électrique sont chargées préalablement, et la phase d'initialisation 14 où des données d'initialisation correspondant audit appareil à contrôler sont mémorisées, une phase de contrôle 15 lance le contrôle lors de l'ouverture de l'appareil électrique.

Dans ce mode de réalisation particulier, une étape 36 détecte l'ouverture de l'appareil électrique. Lorsque l'ouverture est détectée, une étape 37 effectue le contrôle de l'appareil. Cette détection peut être réalisée par un signal extérieur au dispositif ou par l'analyse du signal de mesure ou de sa variation. La phase de contrôle est de préférence lancée à chaque ouverture de l'appareil électrique. Cependant, elle peut aussi être lancée de manière plus espacée, par exemple après un nombre prédéterminé d'ouvertures. Le contrôle peut aussi dépendre le da durée de vie de l'appareil, par exemple le contrôle peut être moins fréquent en début de vie après rodage et plus fréquent en fin de vie pour plus de précision.

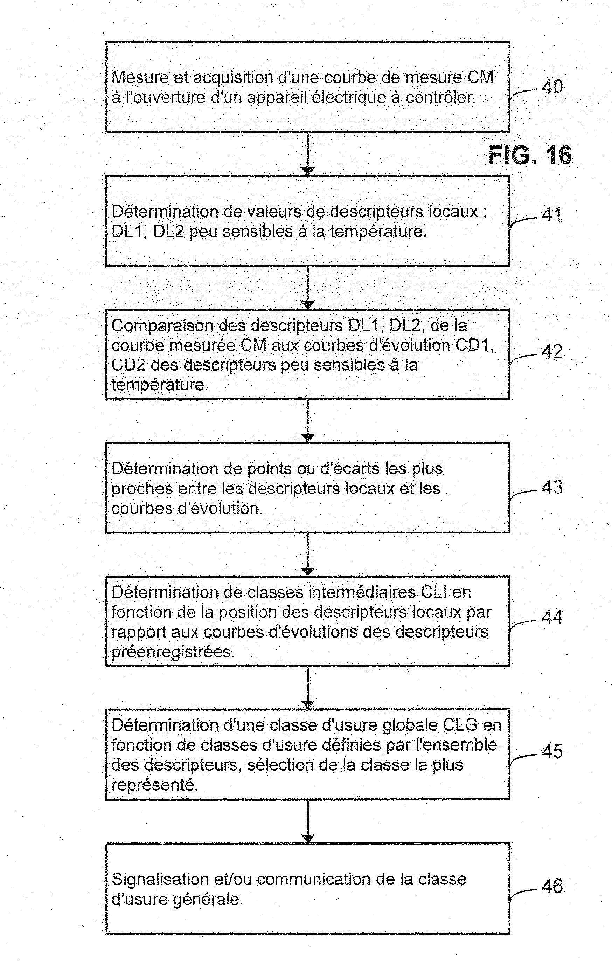

La figure 16 montre un organigramme d'une phase 15 de contrôle avec le détail d'une étape 37 de contrôle selon un mode de réalisation de l'invention.

Ladite phase de contrôle comporte :
- à une étape 40 la mesure et l'acquisition d'une courbe de mesure CM à l'ouverture dudit l'appareil électrique,
- à une étape 41 la détermination de valeur de descripteurs locaux DL1, DL2 de ladite courbe de mesure CM en fonction de valeurs de ladite courbe de mesure CM, de données d'initialisation CRP enregistrées, et de premières données d'apprentissage chargées, au moins un desdits descripteurs locaux DL1, DL2 étant un descripteur peu sensible aux différences de température et dépendant de points remarquables 20 et/ou 21 de ladite courbe le mesure CM,
- à une étape 42 la détermination du positionnement des valeurs de descripteurs locaux DL1, DL2 peu sensibles aux différences de température de la courbe de mesure CM par rapport à des secondes données d'apprentissage CD1, CD2, et
- à des étapes 43-45, la détermination d'une classe d'état globale en fonction desdites valeurs de positionnements des valeurs de descripteurs DL1, DL2 de la courbe de mesure CM par rapport à des secondes données d'apprentissage chargées.

De préférence la détermination d'une classe d'état globale comporte :
- à une étape 43, la détermination de points ou d'écarts les plus proches entre les valeurs de descripteurs locaux DL1, DL2 de la courbe de mesure CM et les courbes d'évolution de descripteurs CD1, CD2 correspondantes,
- à une étape 44, déterminations de classes d'état intermédiaires CLI en fonction de positionnements les plus proches des descripteurs par rapport audites courbes d'évolution de descripteurs,
- à une étape 45, la sélection de ladite classe globale en fonction de résultats desdites classes intermédiaire, et
- à une étape 46, la signalisation ou la communication de la classe d'usure globale de l'appareil.

A l'étape 43, la détermination des écarts les plus proches peut se faire de préférence de manière globale par exemple avec un point définis par les valeurs de tous les descripteurs. Cependant, il peut se faire également individuellement sur chaque descripteur ou de manière mixte ou semi globale avec une partie des descripteurs groupés et une autre partie individuelle.

A l'étape 46, le dispositif 8 de signalisation de l'état de l'appareil électrique peut afficher la classe d'usure globale avec un voyant ou une voie distincte la valeur de classe. Cependant, des valeurs de classe peuvent être regroupées, notamment une classe d'appareil en rodage et une classe de fonctionnement normal peuvent être signalées de manière groupée ou ensembles sur un seul signal.

Selon un mode réalisation de l'invention, le dispositif de diagnostic de l'état d'usure d'un appareil de coupure électrique est connecté à une bobine électromagnétique d'actionnement de contacts d'un appareil de coupure électrique. Il comporte un circuit de traitement pour mettre en oeuvre le procédé de diagnostic décrit ci-dessus.

Un appareil électrique comportant des contacts électriques de puissance actionnés par une bobine électromagnétique de commande selon l'invention comporte un dispositif de diagnostic l'état d'usure d'un appareil de coupure électrique connecté à ladite bobine électromagnétique d'actionnement desdits contacts pour mettre en oeuvre le procédé de diagnostic décrit ci-dessus.

Le dispositif et le procédé peuvent être mis en oeuvre de manière permanente ou temporaire sur l'appareil à contrôler. Ils peuvent aussi être mis en oeuvre sur des appareils électriques déjà installés. De plus, certaines étapes du procédé peuvent être effectuée en local près de l'appareil et d'autres étapes réalisées à distance ou centralisées. Par exemple, les acquisitions des courbes CM peuvent être locales et le reste du traitement peut être réalisé à distance pour des calculs plus élaborés. Dans ce cas, les traitements sont partagés entre un module 7 local et un module 9 distants comme représenté sur la figure 1.

Plusieurs types de charges ou de catégories d'emploi sont identifiés lors des phases d'apprentissage et de contrôle. Le traitement des types de charges est fait de préférence de manière globale lors de la phase d'apprentissage de manière à tenir compte de situations différentes. Par exemple, plusieurs appareils seront utilisés durant une durée de vie pour des types de charge différents. Les courbes d'évolution des descripteurs seront représentatives de courbes avec des appareils ayant eu des charges ou des conditions d'utilisation différentes.

Les catégories d'emploi pour appareils électriques tel que des contacteurs électriques dépendent notamment :
- du type de charge : non inductive, inductive, moteur à bague, moteur à cage ;
- du type de commande : mise sous tension, coupure, démarrage, freinage, marche par à-coup ;
- du type d'applications : distribution, chauffage, compresseur, ventilation, ascenseurs, pompes, machines diverses ; et/ou
- de combinaisons de plusieurs critères.

Il est également possible d'identifier un type de charge ou un usage particulier et de caractériser le procédé en conséquence. Par exemple pour des charges capacitives ou autres.

Des classes d'usure pour chaque catégorie d'emploi sont définies par des descripteurs. Elles permettent de caractériser l'état du produit et d'avoir une indication de la durée de vie du produit.

Une liste des principales classes non limitative peut être :
- Classe 1 : produit neuf ou en rodage,
- Classe 2 : produit en utilisation,
- Classe 3 : produit usé,
- Classe 4 : produit en fin de vie.

Dans les modes de réalisation préférentiels décrits ci-dessus, l'évaluation de l'usure des contacts est faite avantageusement à partir de la mesure de la tension de la bobine du contacteur. Cependant d'autres signaux peuvent être utilisés, notamment un signal représentatif d'un courant circulant dans la bobine.

## Revendications

1. Procédé de diagnostic de l'état d'usure d'un appareil électrique de coupure (1) comportant :
a) une phase (11) d'apprentissage préalable pour relever durant un nombre de manoeuvres prédéterminées des données d'apprentissage (CD1,CD2) représentatives d'au moins deux courbes (CD1, CD2) d'évolution de descripteurs représentatifs de caractéristiques prédéfinies d'un signal électrique durant la vie dudit appareil électrique,
b) une phase (12) de mémorisation desdites données d'apprentissage (CD1, CD2) ;
c) une phase (13) de chargement desdites données d'apprentissage (CD1, CD2) ;
d) une phase (14) d'initialisation pour déterminer et mémoriser des données d'initialisation (CRP) comportant une courbe de référence propre (CRP) dudit appareil électrique (1) à contrôler ; et
e) une phase (15) de contrôle, qui utilise lesdites données d'apprentissage (CD1, CD2) et lesdites données d'initialisation (CRP), ladite phase (15) de contrôle comportant :
- la mesure (40) d'un signal représentatif d'une grandeur électrique et l'acquisition d'une courbe de mesure (CM) dudit signal électrique à l'ouverture dudit appareil électrique,
- la détermination (41) de valeur de descripteurs locaux (DL1, DL2) de ladite courbe de mesure (CM) en fonction de valeurs de ladite courbe de mesure (CM), de données d'initialisation (CRP) enregistrées, et de premières données d'apprentissage chargées, au moins un desdits descripteurs locaux (DL1, DL2) étant un descripteur dont la sensibilité aux différences de température comporte un écart de valeur inférieur à 5% entre -20°C et 80°C, et dépendant de points remarquables (20, 21) de ladite courbe de mesure (CM),
- la détermination (42) du positionnement desdites valeurs de descripteurs locaux (DL1, DL2) de la courbe de mesure (CM) par rapport à des secondes données d'apprentissage (CD1, CD2), et
- la détermination (43-45) d'une classe d'état globale en fonction desdites valeurs de positionnements des valeurs de descripteurs locaux (DL1, DL2) et de la courbe de mesure (CM) par rapport aux dites secondes données d'apprentissage (CD1, CD2).

2. Procédé de diagnostic selon la revendication 1 **caractérisé en ce qu'**un premier descripteur (D1, DL1) correspond à une surface de courbe ou à une intégrale (22) ou intégration commençant à un premier point de la courbe le mesure (CM) dépendant d'un premier point remarquable (20) de ladite courbe le mesure (CM) correspondant à un premier changement de sens de la variation du signal ou de changement de signe de la dérivée dudit signal de mesure, ledit premier point remarquable (20) étant représentatif du début du mouvement d'une partie mobile de l'appareil électrique.

3. Procédé de diagnostic selon la revendication 2 **caractérisé en ce que** l'intégrale (22) du signal commence à un instant t1 compris entre 0 et 10ms avant l'apparition dudit premier point remarquable (20).

4. Procédé de diagnostic selon l'une des revendications 2 ou 3 **caractérisé en ce que** l'intégrale (22) du signal se termine lorsque le signal de la courbe de tension bobine (CM) est nul ou proche de zéro volt.

5. Procédé de diagnostic selon l'une des revendications 2 ou 3 **caractérisé en ce que** l'intégrale (22) du signal dure entre 30 ms et 40 ms.

6. Procédé de diagnostic selon l'une quelconque des revendications 2 à 5, **caractérisé en ce qu'**un second descripteur (D2, DL2) correspond à un positionnement ou à un écart (24) d'un second point remarquable (21) par rapport à une courbe (25) ou une ligne de référence initiale dudit second point remarquable (21) d'un appareil neuf défini sur une plage de température, ledit second point remarquable (21) correspond à une variation de valeur tel que le changement de signe de la variation d'un signal sur la courbe de mesure (CM), ledit signal étant en décroissance puis en croissance en valeur relatives autour du second point remarquable (21).

7. Procédé de diagnostic selon l'une quelconque des revendications 1 à 6 **caractérisé en ce que** des données d'apprentissage chargées sont représentatives de courbes d'évolution (CD1, CD2) de descripteurs (D1, D2) représentatifs de caractéristiques prédéfinies dudit signal électrique durant la vie dudit appareil électriques.

8. Procédé de diagnostic selon la revendication 7, **caractérisé en ce que** lesdites courbes d'évolution de descripteurs (CD1, CD2) sont chargées sous un format de définition de segments de droite pour réduire l'espace mémoire nécessaire audites données d'apprentissage.

9. Procédé de diagnostic selon l'une quelconque des revendications 1 à 8 **caractérisé en ce que** des valeurs desdites courbes d'évolution de descripteurs (CD1, CD2) préchargées sont associées à des classes d'état ou d'usure d'appareils à contrôler.

10. Dispositif de diagnostic (10) de l'état d'usure d'un appareil (1) de coupure électrique connecté à une bobine électromagnétique (4) d'actionnement de contacts (2) dudit appareil de coupure électrique **caractérisé en ce que** le dispositif de diagnostic comporte un circuit (10) de traitement pour mettre en oeuvre le procédé de diagnostic selon les revendications 1 à 9.

11. Dispositif de diagnostic selon la revendication 10 **caractérisé en ce que** le circuit (10) de traitement comporte un module (7) de traitement du diagnostic local proche dudit l'appareil relié à un module de traitement extérieur (9) distant dudit appareil.

12. Appareil électrique (1) comportant des contacts (2) électriques de puissance actionnés par une bobine (4) électromagnétique de commande **caractérisé en ce qu'**il comporte un dispositif de diagnostic (10) de l'état d'usure de l'appareil de coupure électrique connecté à ladite bobine (4) électromagnétique d'actionnement desdits contacts (2) et mettant en oeuvre le procédé de diagnostic selon l'une quelconque des revendications 1 à 9.

## Patentansprüche

1. Verfahren zur Diagnose des Abnutzungszustands eines elektrischen Stromunterbrechungsgeräts (1), das Folgendes umfasst:
a) eine vorausgehende Lernphase (11), um während einer Anzahl von vorbestimmten Vorgängen Lerndaten (CD1, CD2) zu erheben, die für mindestens zwei Verlaufskurven (CD1, CD2) von Deskriptoren repräsentativ sind, die für vordefinierte Eigenschaften eines elektrischen Signals während der Lebensdauer des elektrischen Geräts repräsentativ sind,
b) eine Phase (12) des Speicherns der Lerndaten (CD1, CD2);
c) eine Phase (13) des Ladens der Lerndaten (CD1, CD2);
d) eine Initialisierungsphase (14), um Initialisierungsdaten (CRP) zu bestimmen und zu speichern, die eine eigene Referenzkurve (CRP) des zu kontrollierenden elektrischen Geräts (1) umfassen; und
e) eine Kontrollphase (15), die die Lerndaten (CD1, CD2) und die Initialisierungsdaten (CRP) verwendet, wobei die Kontrollphase (15) Folgendes umfasst:
- Messen (40) eines Signals, das für eine elektrische Größe repräsentativ ist, und Erfassen einer Messkurve (CM) des elektrischen Signals beim Öffnen des elektrischen Geräts,
- Bestimmen (41) eines Werts von lokalen Deskriptoren (DL1, DL2) der Messkurve (CM) in Abhängigkeit von Werten der Messkurve (CM), von erfassten Initialisierungsdaten (CRP) und von geladenen ersten Lerndaten, wobei mindestens einer der lokalen Deskriptoren (DL1, DL2) ein Deskriptor ist, dessen Empfindlichkeit gegenüber Temperaturunterschieden eine Wertabweichung kleiner als 5 % zwischen -20 °C und 80 °C umfasst, und von markanten Punkten (20, 21) der Messkurve (CM) abhängt,
- Bestimmen (42) der Position der Werte von lokalen Deskriptoren (DL1, DL2) der Messkurve (CM) mit Bezug auf zweite Lerndaten (CD1, CD2) und
- Bestimmen (43-45) einer globalen Zustandsklasse in Abhängigkeit von den Positionswerten der Werte von lokalen Deskriptoren (DL1, DL2) und der Messkurve (CM) mit Bezug auf die zweiten Lerndaten (CD1, CD2).

2. Diagnoseverfahren nach Anspruch 1, **dadurch gekennzeichnet, dass** ein erster Deskriptor (D1, DL1) einer Kurvenfläche oder einem Integral (22) oder einer Integration entspricht, die/das an einem ersten Punkt der Messkurve (CM) beginnt, welcher von einem ersten markanten Punkt (20) der Messkurve (CM), der einer ersten Richtungsänderung der Variation des Signals oder Vorzeichenänderung der Ableitung des Messsignals entspricht, abhängt, wobei der erste markante Punkt (20) für den Beginn der Bewegung eines beweglichen Teils des elektrischen Geräts repräsentativ ist.

3. Diagnoseverfahren nach Anspruch 2, **dadurch gekennzeichnet, dass** das Integral (22) des Signals zu einem Zeitpunkt t1 beginnt, der zwischen 0 und 10 ms vor Auftreten des ersten markanten Punkts (20) liegt.

4. Diagnoseverfahren nach einem der Ansprüche 2 oder 3, **dadurch gekennzeichnet, dass** das Integral (22) des Signals endet, wenn das Signal der Spulenspannungskurve (CM) null oder nahe null Volt ist.

5. Diagnoseverfahren nach einem der Ansprüche 2 oder 3, **dadurch gekennzeichnet, dass** das Integral (22) des Signals zwischen 30 ms und 40 ms dauert.

6. Diagnoseverfahren nach einem beliebigen der Ansprüche 2 bis 5, **dadurch gekennzeichnet, dass** ein zweiter Deskriptor (D2, DL2) einer Position oder einer Abweichung (24) eines zweiten markanten Punkts (21) mit Bezug auf eine Kurve (25) oder eine anfängliche Referenzlinie des zweiten markanten Punkts (21) eines neuen Geräts, der über einen Temperaturbereich definiert ist, entspricht, der zweite markante Punkt (21) einer Wertevariation wie etwa der Vorzeichenänderung der Variation eines Signals auf der Messkurve (CM) entspricht, wobei das Signal um den zweiten markanten Punkt (21) herum relativ betrachtet erst abfällt und dann ansteigt.

7. Diagnoseverfahren nach einem beliebigen der Ansprüche 1 bis 6, **dadurch gekennzeichnet, dass** geladene Lerndaten für Verlaufskurven (CD1, CD2) von Deskriptoren (D1, D2) repräsentativ sind, die für vordefinierte Eigenschaften des elektrischen Signals während der Lebensdauer des elektrischen Geräts repräsentativ sind.

8. Diagnoseverfahren nach Anspruch 7, **dadurch gekennzeichnet, dass** die Verlaufskurven von Deskriptoren (CD1, CD2) in einem Definitionsformat von Liniensegmenten geladen werden, um den benötigen Speicherplatz für die Lerndaten zu reduzieren.

9. Diagnoseverfahren nach einem beliebigen der Ansprüche 1 bis 8, **dadurch gekennzeichnet, dass** Werte der vorab geladenen Verlaufskurven von Deskriptoren (CD1, CD2) Zustands- oder Abnutzungsklassen zu kontrollierender Geräte zugeordnet sind.

10. Vorrichtung zur Diagnose (10) des Abnutzungszustands eines elektrischen Stromunterbrechungsgeräts (1), die mit einer elektromagnetischen Spule (4) zur Betätigung von Kontakten (2) des elektrischen Stromunterbrechungsgeräts verbunden ist, **dadurch gekennzeichnet, dass** die Diagnosevorrichtung eine Verarbeitungsschaltung (10) zur Umsetzung des Diagnoseverfahrens nach den Ansprüchen 1 bis 9 umfasst.

11. Diagnosevorrichtung nach Anspruch 10, **dadurch gekennzeichnet, dass** die Verarbeitungsschaltung (10) ein lokales Diagnoseverarbeitungsmodul (7) in der Nähe des Geräts umfasst, das mit einem externen Verarbeitungsmodul (9), das von dem Gerät entfernt ist, verbunden ist.

12. Elektrisches Gerät (1), das elektrische Leistungskontakte (2) umfasst, die durch eine elektromagnetische Steuerspule (4) betätigt werden, **dadurch gekennzeichnet, dass** es eine Vorrichtung zur Diagnose (10) des Abnutzungszustands des elektrischen Stromunterbrechungsgeräts umfasst, die mit der elektromagnetischen Spule (4) zur Betätigung der Kontakte (2) verbunden ist und das Diagnoseverfahren nach einem beliebigen der Ansprüche 1 bis 9 umsetzt.

## Claims

1. Method for diagnosing the state of wear of an electrical switching device (1) comprising:
a) a preliminary learning phase (11) for recording, over a predetermined number of manoeuvres, learning data (CD1, CD2) representative of at least two trend curves (CD1, CD2) of descriptors representative of predefined characteristics of an electrical signal during the life of said electrical device,
b) a phase (12) of storage of said learning data (CD1, CD2);
c) a phase (13) of loading of said learning data (CD1, CD2);
d) an initialization phase (14) for determining and storing initialization data (CRP) comprising a specific reference curve (CRP) of said electrical device (1) to be checked; and
e) a checking phase (15), which uses said learning data (CD1, CD2) and said initialization data (CRP), said checking phase (15) comprising:
- the measurement (40) of a signal representative of an electrical quantity and the acquisition of a measurement curve (CM) of said electrical signal when said electrical device is switched off,
- the determination (41) of the value of local descriptors (DL1, DL2) of said measurement curve (CM) as a function of values of said measurement curve (CM), of stored initialization data (CRP), and of first loaded learning data, at least one of said local descriptors (DL1, DL2) being a descriptor for which the sensitivity to temperature differences includes a deviation of less than 5% in value between -20°C and 80°C, and dependent on noteworthy points (20, 21) of said measurement curve (CM),
- the determination (42) of the positioning of said local descriptor values (DL1, DL2) of the measurement curve (CM) with respect to second learning data (CD1, CD2), and
- the determination (43-45) of an overall state class as a function of said positioning values of the local descriptor values (DL1, DL2) and of the measurement curve (CM) with respect to said second learning data (CD1, CD2).

2. Diagnostic method according to Claim 1, **characterized in that** a first descriptor (D1, DL1) corresponds to an under-curve area or to an integral (22) or integration beginning at a first point of the measurement curve (CM) dependent on a first noteworthy point (20) of said measurement curve (CM) corresponding to a first change of direction of the variation of the signal or change of sign of the derivative of said measurement signal, said first noteworthy point (20) being representative of the start of the movement of a movable part of the electrical device.

3. Diagnostic method according to Claim 2, **characterized in that** the integral (22) of the signal begins at an instant t1 lying between 0 and 10 ms before the appearance of said first noteworthy point (20).

4. Diagnostic method according to one of Claims 2 and 3, **characterized in that** the integral (22) of the signal ends when the signal of the coil voltage curve (CM) is nil or close to zero Volt.

5. Diagnostic method according to one of Claims 2 and 3, **characterized in that** the integral (22) of the signal lasts between 30 ms and 40 ms.

6. Diagnostic method according to any one of Claims 2 to 5, **characterized in that** a second descriptor (D2, DL2) corresponds to a positioning or to a deviation (24) of a second noteworthy point (21) with respect to a curve (25) or an initial reference line of said second noteworthy point (21) of a new device defined over a temperature range, said second noteworthy point (21) corresponds to a variation of value such as the change of sign of the variation of a signal on the measurement curve (CM), said signal decreasing then increasing in relative values around the second noteworthy point (21).

7. Diagnostic method according to any one of Claims 1 to 6, **characterized in that** loaded learning data are representative of trend curves (CD1, CD2) of descriptors (D1, D2) representative of predefined characteristics of said electrical signal during the life of said electrical device.

8. Diagnostic method according to Claim 7, **characterized in that** said descriptor trend curves (CD1, CD2) are loaded in a straight segment definition format to reduce the memory space necessary for said learning data.

9. Diagnostic method according to any one of Claims 1 to 8, **characterized in that** values of said preloaded descriptor trend curves (CD1, CD2) are associated with state or wear classes of devices to be checked.

10. Diagnostic device (10) for diagnosing the state of wear of an electrical switching device (1) connected to an electromagnetic actuation coil (4) for actuating contacts (2) of said electrical switching device, **characterized in that** the diagnostic device comprises a processing circuit (10) for implementing the diagnostic method according to Claims 1 to 9.

11. Diagnostic device according to Claim 10, **characterized in that** the processing circuit (10) comprises a local diagnostic processing module (7) close to said device linked to an external processing module (9) remote from said device.

12. Electrical device (1) comprising power electrical contacts (2) actuated by a control electromagnetic coil (4), **characterized in that** it comprises a diagnostic device (10) for diagnosing the state of wear of the electrical switching device connected to said electromagnetic actuation coil (4) for actuating said contacts (2) and implementing the diagnostic method according to any one of Claims 1 to 9.
